# EUROPEAN PATENT APPLICATION

(11) **EP 1 703 509 A1**
(43) Date of publication of application: **20.09.2006**
(21) Application number: 05110451.1
(22) Date of filing: 08.11.2005
(51) Int. Cl.: G11B 20/18, H03M 13/15

(54) **Error correction processing unit and error correction processing method**

(30) Priority: 28.12.2004 JP 2004381561
(71) Applicant: KABUSHIKI KAISHA TOSHIBA, Tokyo 105-8001 (JP)
(72) Inventor: Takahashi, Kyosuke Toshiba Corporation, Minato-ku, Tokio 105-8001 (JP); Tatsuzawa, Yukiyasu Toshiba Corporation, Minato-ku, Tokio 105-8001 (JP)
(74) Representative: Henkel, Feiler & Hänzel

(57) **Abstract**

The present invention comprises generating sections (45a, 45b) which generate intermediate information for error correction processing in units of surfaces from an error correction block stored in a first storage section (42), the error correction block having A/B surfaces, second storage sections (47, 48) which store intermediate information, a processing section (45c) which generates correction information that carries out error correction processing in several units divided within units of surfaces for the error correction block stored in the first storage section (42) on the basis of the intermediate information, and control sections (43, 44, 46, 52, 53) which correlate position information of the error correction block with position information in units of surfaces for use in the generating sections (45a, 45b), the second storage sections (47, 48), and the processing section (45c).

## Description

The present invention relates to improvement in an error correction processing unit and an error correction processing method for use in, for example, an optical disk device, etc.

As is generally known, nowadays, optical disks such as a digital versatile disk (DVD), etc. are popularly accepted as digital recording media. In an optical disk device which plays back these optical disks, high reliability is desired.

Now, for DVDs, the standard itself has been evolved and the next-generation DVD standard that supports high-definition TVs has already been completed. Because in the next-generation DVD standard, the recording density is remarkably increased than that of the current DVD, the optical disk device is required to carry out still higher data processing, in particular, error correction processing.

Jpn. Pat. Appln. KOKAI Publication No. 2003-208751 discloses a configuration to achieve the increased speed of error correction processing by reducing the number of accesses of an optical disk controller to an external buffer memory. That is, part of ECC (error checking and correcting) block data is transferred to a work memory in the optical disk controller as it is, and thereafter, error correction processing is carried out on the basis of the data in the work memory. In such a case, a unit which is smaller than a product-coded unit is assumed for part of the ECC block data.

The present invention has been made with the above circumstances taken into account, and an object of the present invention is to provide an error correction processing unit and an error correction processing method that can achieve efficient and high-speed error correction processing with an increase in circuit scale suppressed.

According to one aspect of the present invention, there is provided an error correction processing unit comprising: a first storage section configured to store an error correction block having first and second surfaces; generating sections to which the error correction block stored in the first storage section is supplied in units of surfaces and which are configured to generate intermediate information for error correction processing in the units of surfaces; second storage sections configured to store the intermediate information generated in the generating sections in units of surfaces; a processing section configured to generate correction information to carry out error correction processing in several units divided within surface units to the error correction block stored in the first storage section on the basis of the intermediate information stored in the second storage sections; and control sections configured to correlate position information of the error correction block stored in the first storage section with position information in units of surfaces for use in the generating sections, the second storage sections and the processing section.

According to another aspect of the present invention, there is provided an error correction processing method comprising: a first step of storing an error correction block having first and second surfaces in a first storage section; a second step of generating intermediate information for error correction processing in units of surfaces by generating sections from data of the first surface of the error correction block stored in the first storage section; a third step of storing intermediate information for the first surface of the error correction block generated in the generating sections in the second storage sections in units of surfaces; a fourth step of generating correction information to carry out error correction processing in several units divided within surface units for the data of the first surface of the error correction block stored in the first storage section by means of a processing section on the basis of the intermediate information for the first surface of the error correction block stored in the second storage sections; a fifth step of generating intermediate information for error correction processing in units of surfaces by the generating sections from data of the second surface of the error correction block stored in the first storage section; a sixth step of storing the intermediate information for the second surface of the error correction block generated in the generating sections in the second storage sections in units of surfaces; and a seventh step of generating correction information to carry out error correction processing in several units divided within surface units for the data of the second surface of the error correction block stored in the first storage section by means of the processing section on the basis of the intermediate information for the second surface of the error correction block stored in the second storage sections.

This summary of the invention does not necessarily describe all necessary features so that the invention may also be a sub-combination of these described features.

The invention can be more fully understood from the following detailed description when taken in conjunction with the accompanying drawings, in which:
FIG. 1 shows one embodiment of the present invention and is a block diagram for explaining an optical disk device;
FIG. 2 is a diagram for explaining one example of a pickup of the optical disk device in the embodiment;
FIG. 3 is a diagram for explaining a structure of 1 ECC data block in the next-generation DVD standard;
FIG. 4 is a block diagram for explaining one example of an error correction processing circuit of the optical disk device in the embodiment;
FIG. 5 is a diagram for explaining a data block in the unit of one surface handled by a correction execution processing circuit of the optical disk equipment in the embodiment;
FIG. 6 is a block diagram for explaining a mechanism shaped by a circuit group on the correction processing execution side of the optical disk equipment in the embodiment in processing each surface;
FIG. 7 is a diagram for explaining the relation between position information in the ECC block and position information in the surface by an A/B surface access switching circuit of the optical disk equipment in the embodiment; and
FIG. 8 is a flow chart for explaining a main processing operation of the optical disk equipment in the embodiment.

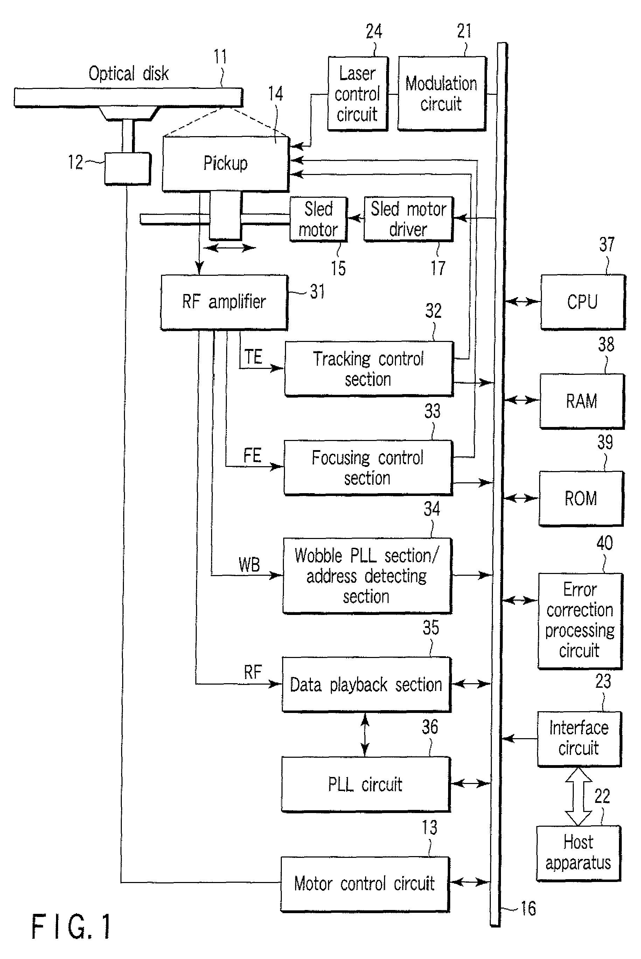

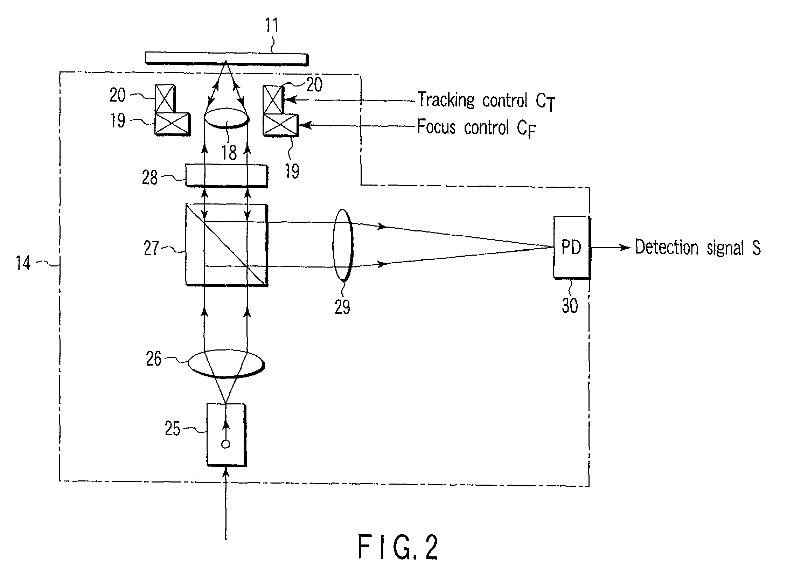

An embodiment of the present invention will be described in detail hereinafter with reference to the accompanying drawings. An optical disk device according to this embodiment has a configuration as shown in FIGS. 1 and 2. Now, for an optical disk 11, an optical disk in which user data can be recorded (or rewritten) or a read-only optical disk is subject of the present invention. In this embodiment, explanation will be made on a recordable (or rewritable) optical disk.

Examples of the recordable or rewritable optical disk 11 include a next-generation DVD-RAM (random access memory) DVD-RW (rewritable), DVD-R (recordable), etc. using blue-based laser beam with wavelength of about 405 nm, or a current DVD-RAM, DVD-RW, DVD-R, etc. using red-based laser beam with wavelength of about 650 nm.

On the surface of the optical disk 11, land tracks and groove tracks are formed in a spiral form. The optical disk 11 is driven to rotate by a spindle motor 12. The rotating speed of the spindle motor 12 is controlled by a motor control circuit 13.

Information is recorded to or played back from the optical disk 11 by a pickup 14. The pickup 14 is coupled to a sled motor 15 via gears. The sled motor 15 is controlled by a sled motor driver 17 connected to a data bus 16. A permanent magnet (not shown) is installed at the fixed section of the sled motor 15, and the pickup 14 moves in the radial direction of the optical disk 11 by energizing a driving coil (not shown).

An objective lens 18 is provided on the pickup 14 as shown in FIG. 2. The objective lens 18 can be moved in a focusing direction (optical axis direction of a lens) by the drive of a driving coil 19, and can be also moved in a tracking direction (direction that cuts the lens optical axis at right angles) by the drive of a driving coil 20. Track jump can be carried out by moving the beam spot of the laser beam.

A modulation circuit 21 generates EFM (eight to fourteen modulation) data by, for example, 8-14 modulating user data supplied from a host unit 22 to an interface circuit 23 at the time of recording information. A laser control circuit 24 provides writing signals to a semiconductor laser diode 25 on the basis of the EFM data supplied from a modulation circuit 21 at the time of recording information (at the time of forming marks).

In addition, the laser control circuit 24 provides reading signals of a level smaller than the writing signals to the semiconductor diode 25 at the time of reading information.

The semiconductor laser diode 25 generates laser beam in accordance with the writing signal supplied from the laser control circuit 24. The laser beam emitted from the semiconductor laser diode 25 is illuminated on the optical disk 11 via a collimator lens 26, a half prism 27, an optical system 28, and the objective lens 18. The light reflected from the optical disk 11 is guided to a photodetector 30 via the objective lens 18, the optical system 28, the half prism 27, and a condenser 29.

The photodetector 30 comprises quartered photodetection cells, and supplies signals A, B, C and D to a radio frequency (RF) amplifier 31. The RF amplifier 31 adopts, for example, a push-pull system to supply a tracking error signal TE that corresponds to (A+D)-(B+C) to a tracking control section 32, and adopts, for example, an astigmatic method to supply a focus error signal FE that corresponds to (A+C)-(B+D) to a focusing control section 33.

Furthermore, the RF amplifier 31, for example, supplies a wobble signal WB that corresponds to the (A+D)-(B+C) to a wobble PLL section/address detecting section 34, and supplies an RF signal that corresponds to (A+D)+(B+C) to a data playback section 35.

On the other hand, an output signal of the focusing control section 33 is supplied to the driving coil 19 in the focusing direction. Thereby, control is carried out in such a manner that the laser beam is constantly just-focused on a recording film of the optical disk 11. In addition, the tracking control section 32 generates a track driving signal in accordance with the tracking error signal TE, and supplies the generated signal to the driving coil 20 in the tracking direction.

With the focusing control and tracking control conducted, a sum signal RF of output signals of the photodetection cells of the photodetector 30 is reflected with changes in reflectance from a pit, etc. formed on the track of the optical disk 11 in compliance with the recorded information. This signal is supplied to the data playback section 35.

The data playback section 35 plays back recorded data on the basis of a playback clock signal from a PLL circuit 36. The data playback section 35 also has a function to measure amplitudes of the signal RF, and the measured value is read by a central processing unit (CPU) 37.

While the objective lens 18 is controlled by the tracing control section 32, the pickup 14 is controlled due to the sled motor 15 being controlled in such a manner that the objective lens 18 assumes the optimum position of the optical disk 11.

The motor control circuit 13, laser control circuit 24, focusing control section 33, tracking control section 32, data playback section 35, PLL circuit 36, etc. may be configured in one LSI (large scale integration) chip as a servo control circuit.

These circuit sections are controlled by the CPU 37 via the bus 16. The CPU 37 comprehensively controls the optical disk device in accordance with an operation command provided from the host unit 22 via the interface circuit 23.

Further, the CPU 37 uses a RAM 38 as a work area, and carries out a predetermined operation in compliance with a program recorded on a read only memory (ROM) 39.

The data played back by the data playback section 35 is used to play back pictures, sub-pictures, voices, and others after the data is provided with error correction treatment by an error correction processing circuit 40.

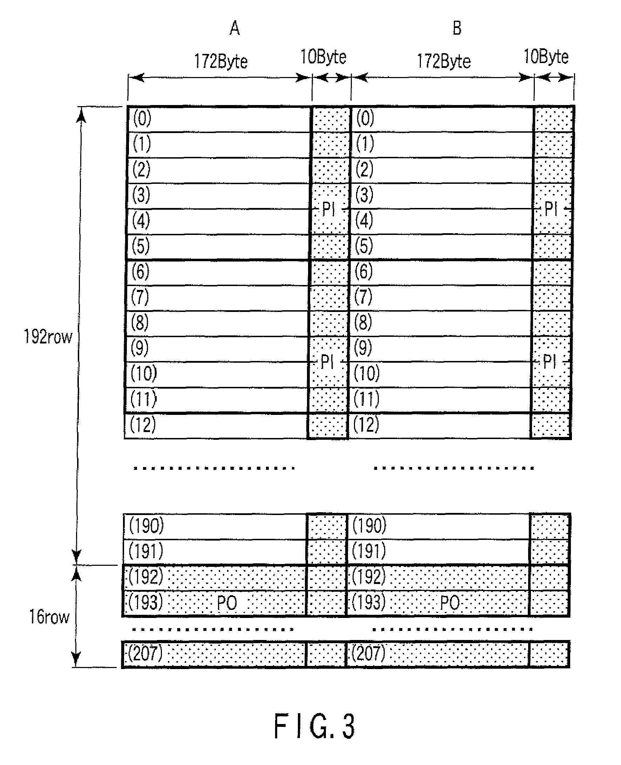

FIG. 3 shows a structure of a 1 ECC data block, which is an error correction block in the next-generation DVD standard. This 1 ECC data block is divided into two parts, namely, surface A (first) and surface B (second), and the respective surfaces are product-coded.

In the respective surfaces A, B, an error correction code in a PO direction is an RS code which has a code length of 208 bytes, an information length of 192 bytes, and the minimum distance of 17, and an error correction code in a PI direction is an RS code which has a code length of 182 bytes, an information length of 172 bytes, and the minimum distance of 11.

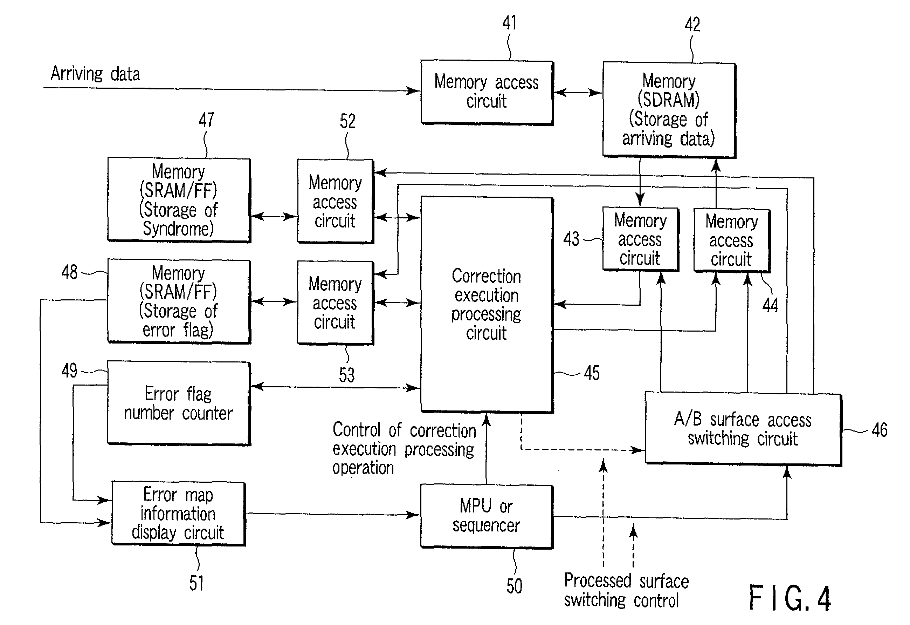

FIG. 4 shows one example of the error correction processing circuit 40. In this error correction processing circuit 40, signals read from the optical disk 11 which is the next-generation DVD undergo digitization processing, modulation processing, and synchronous detection processing before arriving as the ECC block data shown in FIG. 3 together with the position information in the ECC block.

The arriving data is correlated with position information (address) stored in a memory 42 for arriving data storage by means of a memory access circuit 41 on the basis of the corresponding position information in the ECC block, and access control for storage is carried out. As the memory 42, an SDRAM, etc. which is of a large capacity and is not high speed from the viewpoint of access speed is assumed. For the memory 42, shared use may be carried out at the RAM 38 which serves as a work memory.

The ECC block data which has arrived is stored in the memory 42 in an appropriate format with the storage efficiency, access efficiency at the memory access circuit 41, and access efficiency (this depends on characteristics of the memory 42) of each of access circuits 43, 44 later discussed added.

In this case, for example, the area may be divided by surface A and surface B, or original data and parity data (PO/PI) which are subject to coding may be further divided by areas, respectively. At any rate, some kind of correlation is achieved between position information in the ECC block of the ECC block data shown in FIG. 3 and a stored position (address) of the memory 42, and storage is carried out.

The memory access circuit 43 carries out access for reading from the memory 42 in the order suited to the correction execution processing circuit 45 by correlating the storage position information of arriving data stored in the memory 42 with the position information in the ECC block of the data used in the correction execution processing circuit 45.

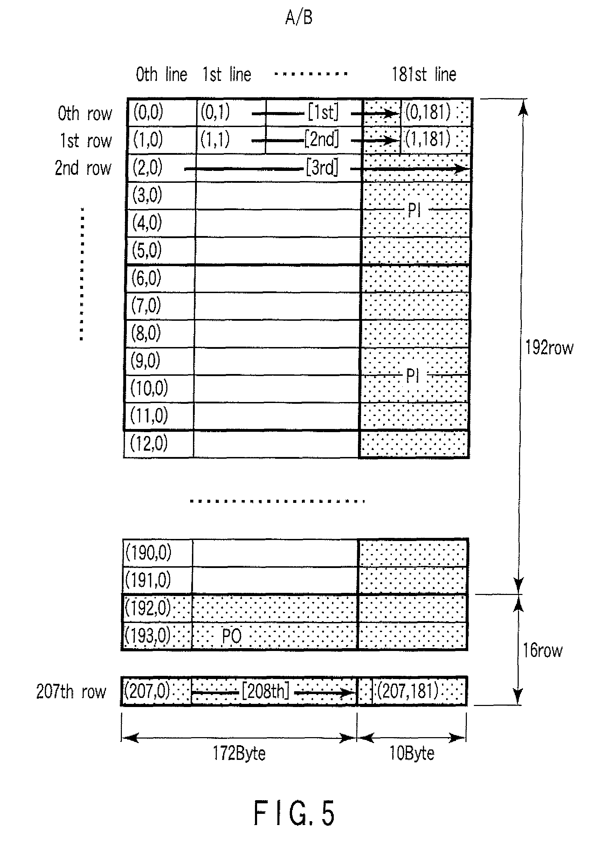

Reading of data from the memory 42 by the memory access circuit 43, that is, data input to the correction execution processing circuit 45 is carried out, respectively, in units of data of each of surfaces A and B. For the order of reading (inputting) the data, for example, as shown in FIG. 5, the data is inputted sequentially from the data on the 0th line and 0th row clockwise to the data on the 207th line and the 181st row.

Conversely, the data may be inputted sequentially from the data on the 207th line and 181st row counterclockwise to the 0th line and 0th row. Furthermore, the data may be inputted sequentially from the 0th line and 0th row downwards to the data on the 207th line and 181st line, and conversely, from the data on the 207th line and 181st line upwards to the data on the 0th line and the 0th row.

In addition, the memory access circuit 44 receives error pattern information as a result of correction execution processing and error position information in each of surfaces A and B from the correction execution processing circuit 45, correlates the information with the stored position of the memory 42, and has access to the memory 42 in order to update the internal information.

In this case, the memory access circuit 44 has access to the memory 42 in accordance with the position information in the ECC block and data updating information received via an A/B surface access switching circuit 46.

Note that the memory access circuits 43, 44 and correction execution processing circuit 45 are assumed to be equipped with a buffer of a capacity necessary for transferring the ECC block data, etc., respectively.

In the A/B surfaces access switching circuit 46, the position information in each of surfaces A, B recognizable by the correction execution processing circuit 45 is exchanged with the position information in the ECC block required by the memory access circuits 43, 44.

Now, the correction execution processing circuit 45 is a circuit to carry out correction execution processing in units of surfaces. That is, the correction execution processing circuit 45 generates all the syndromes in the PI direction and PO direction in the surface by the data in units of surfaces shown in FIG. 5 being inputted in the order suited for the correction execution processing circuit 45. Also, the correction execution processing circuit 45 detects presence/absence of error in the PI direction and in the PO direction on the basis of the generated syndromes, and generates error flags. These syndromes and error flags are stored in memories 47, 48, respectively.

The error flag generated at the correction execution processing circuit 45 is supplied to the error flag number counter 49, and the number of error flags is counted in the PI direction and PO direction.

Based on the intermediate information (syndromes, error flags, the number of error flags) generated in this way, now, the correction execution processing circuit 45 executes error correction processing (derivation of error pattern information and error position information) and outputs these items of correction information.

This processing decides and executes a processing amount, a processing direction (PI/PO direction), places to be processed, a correction execution mode (use or non-use of erasure), etc. in accordance with the appropriate algorithm with the data unit coded in the PI direction and PO direction set as the minimum unit.

A micro processing unit (MPU) 50 may be allowed to carry out the decision, or a sequencer 50 comprising HW only may be allowed to carry out the decision. In such a case, error pattern information and error position information are extracted as the executed results. At the same time, updating is carried out for syndromes, error flags, and error flag number counter values as needed on the basis of processing results, and by keeping consistency by the start of the following correction execution processing groups, the information are used as information to decide the following processing operations.

Conditions of completing processing in units of surfaces are decided by establishing certain appropriate conditions that meet applications, and processing of the next surface takes place. Detection of completion of the surface unit as well as setting and start of operations for the following surface processing may be controlled by the MPU 50 or the sequencer 50 which comprises HW only.

A memory with comparatively small capacity as compared to the memory 42 and with higher speed (SRAM, etc.) is used for each of the memories 47, 48. The memory 47 stores the syndromes generated at the correction execution processing circuit 45. In this case, syndromes in the PI direction and PO direction, respectively, in the unit of one surface are stored. This not only stores the results of syndrome calculations by first obtaining data for one surface from the memory 42 by means of the correction execution processing circuit 45 as described above, but also updates the content every time correction execution processing (derivation of error pattern information and error position information) is carried out.

The memory 48 stores the error flags generated in the correction execution processing circuit 45. In this case, error flags in the PI direction and PO direction, respectively, in the unit of one surface are stored. This not only stores the results of error flag generation by obtaining data for one surface from the memory 42 by means of the correction execution processing circuit 45 as described above, but also updates the content every time correction execution processing (derivation of error pattern information and error position information) is carried out.

The error flag number counter 49 counts the number of error flags generated in the correction execution processing circuit 45 in the PI direction and in the PO direction, respectively. This not only carries out counting when error flags are generated by first obtaining data for one surface from the memory 42 by means of the correction execution processing circuit 45, but also updates the count every time correction execution processing (derivation of error pattern information and error position information) is carried out.

An error map information display circuit 51 extracts and displays error map information from error flag information stored in the memory 48 and error flag number information counted by the error flag number counter 49, etc. as well as outputs the information to the MPU 50. Thereby, the MPU 50 designates the operation of correction execution processing by appropriate algorithm. In addition, these items of error map information may be displayed on the sequencer 50 comprising HW only so that the operation processing content is decided in the way of hardware.

The MPU 50 or the sequencer 50 comprising HW only designates a correction execution processing operation on the basis of various kinds of setting information related to correction execution processing and error map information from the error map information display circuit 51.

The memory access circuit 52 achieves access for syndrome storage/updating for the memory 47. In addition, the memory access circuit 53 achieves access for error flag storage/updating for the memory 48.

FIG. 5 shows a data block image in the unit of one surface (surface A/surface B) which the correction execution processing circuit 45 handles. This data block is inputted in the correction execution processing circuit 45 in order assumed in the correction execution processing circuit 45. The order shall, for example, be as described above. FIG. 5 shows one example, in which the data block is sequentially inputted in order from the 0th line and 0th row clockwise to the 207th line and 181st row.

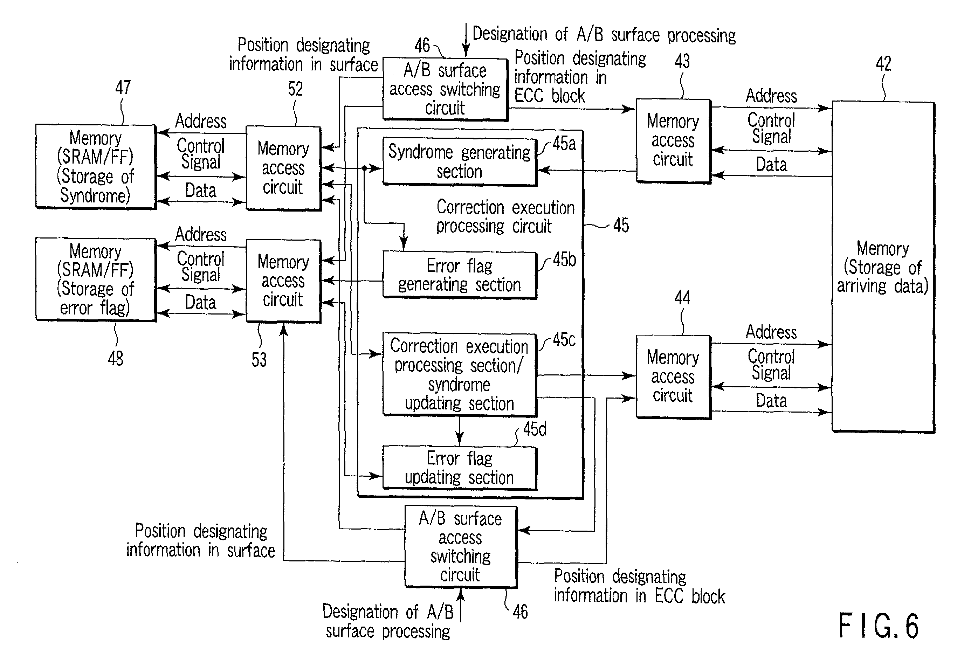

FIG. 6 outlines a mechanism which the circuit group on the correction processing execution side comprising the correction execution processing circuit 45, the memory 47 for syndrome storage, the memory 48 for error flag storage, the memory access circuits 52, 53 for the respective memories 47, 48, shares in processing of surface A and surface B, respectively.

The correction execution processing circuit 45 comprises in detail a syndrome generating section 45a, an error flag generating section 45b, a correction execution processing section (extraction of error pattern information, error position information)/syndrome updating section 45c, an error flag updating section 45d, and the like.

As the whole of the circuit group on the correction processing execution side, the recognizable maximum data block unit is the surface unit. By realizing correlation with the position information in the ECC block with surface designation (surfaces A/B) added with respect to the recognition of position information in units of surfaces by means of A/B surface access switching circuit 46, the circuit group on the correction processing execution side can be shared.

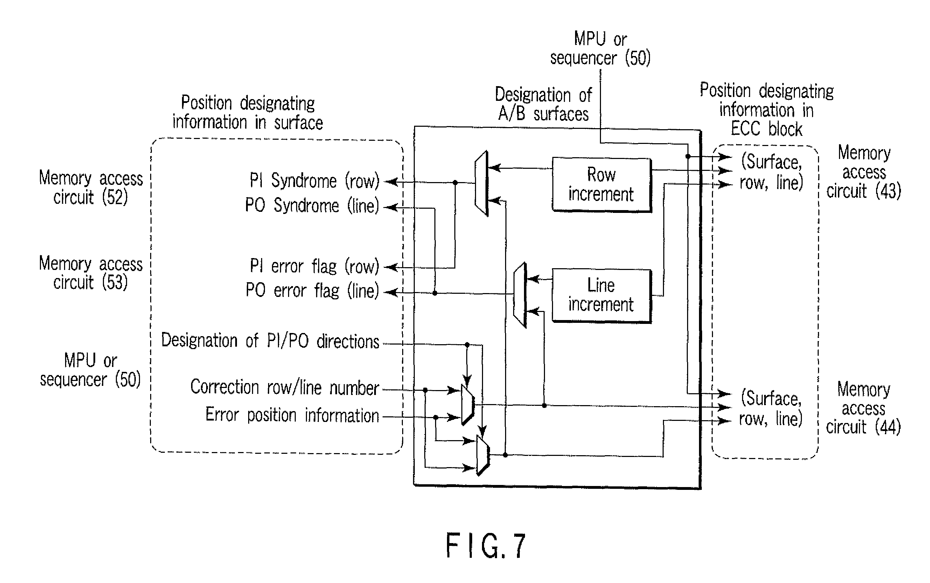

FIG. 7 shows an outline of the relation between position information in the ECC block and position information by means of the surface by A/B surface access switching circuit 46.

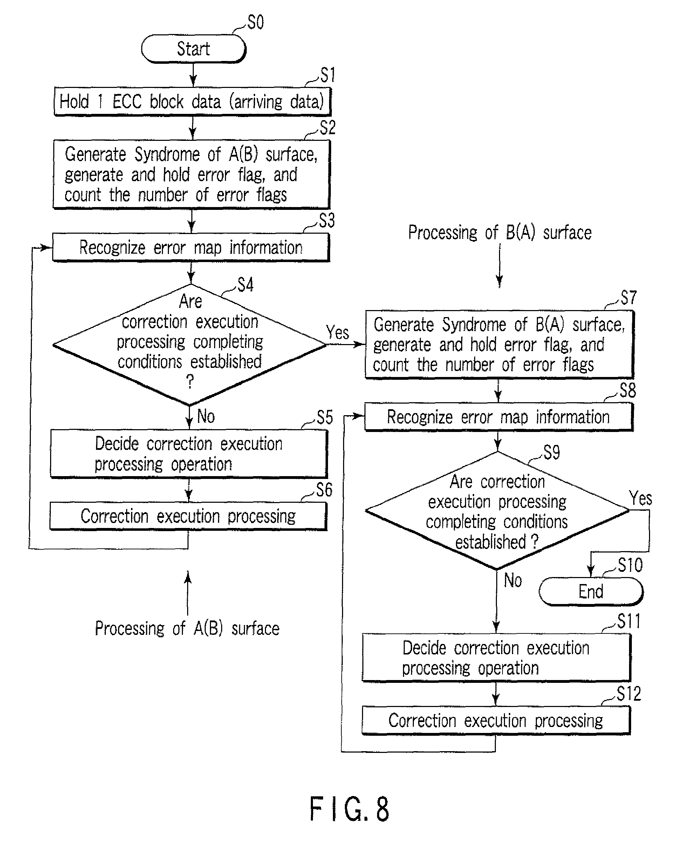

FIG. 8 is a flow chart that summarizes main processing operations of the error correction processing circuit 40 shown in FIG. 4. That is, when operation is started (step S0), the arriving data is held in the memory 42 in step S1.

In step S2, by the correction execution processing circuit 45, syndromes are generated, error flags are generated, and the number of error flags is counted with respect to surface A (or B) of ECC block data.

Thereafter, in step S3, the error map information extracted by the error map information display circuit 51 is recognized by the MPU 50 or sequencer 50 comprising HW only, and in step S4, it is determined whether or not the correction execution processing completion conditions in units of surfaces are established. In the case where it is determined that correction execution processing completing conditions have not been established in units of surfaces (No), correction execution processing operation is decided in step S5, and in step S6, correction execution processing is carried out and operation is returned to processing of step S3.

In the step S4, in the case where it is determined that correction execution processing completing conditions have been established in units of surfaces (Yes), operation moves to processing of the following surface, and in step S7, by the correction execution processing circuit 45, syndromes are generated, error flags are generated, and the number of error flags is counted with respect to surface B (or A) of the ECC block data.

Thereafter, in step S8, the error map information extracted by the error map information display circuit 51 is recognized by the MPU 50 or sequencer 50 comprising HW only, and in step S9, it is determined whether or not correction execution processing completing conditions have been established in units of surfaces. In the case where it is determined that correction execution processing completing conditions have been established in units of surfaces (Yes), processing is ended (step S10).

In step S9, in the case where it is determined that correction execution processing completing conditions have not been established (No), a correction execution processing action is decided in step S11, and in step S12, correction execution processing is carried out, and operation is returned to processing of step S8.

According to the above-mentioned embodiment, because one correction execution processing circuit 45 is effectively used by surface A and surface B of the ECC data block to achieve error correction processing, it becomes possible to achieve high-speed and highly efficient error correction processing by a comparatively simple circuit configuration. It also becomes possible to suppress the circuit scale while maintaining performance. By realizing an efficient circuit at high speed, the degree of responding to competitions can be improved to meet the double speed in the next-generation optical disk where high density transfer speed is essential.

The present invention is not limited to the above-mentioned embodiment as it is but in the stages of practicing the invention, constituent elements may be changed and modified in various ways without departing from the spirit and the scope thereof. In addition, by suitably combining a plurality of constituent elements disclosed in the embodiment, various inventions could be formed. For example, several constituent elements may be deleted from all the constituent elements shown in the embodiment. Furthermore, constituent elements according to different embodiments may be suitably combined.

## Claims

1. An error correction processing unit **characterized by** comprising:
a first storage section (42) configured to store an error correction block having first and second surfaces (A/B);
generating sections (45a, 45b) to which the error correction block stored in the first storage section (42) is supplied in units of surfaces and which are configured to generate intermediate information for error correction processing in the units of surfaces;
second storage sections (47, 48) configured to store the intermediate information generated in the generating sections (45a, 45b) in units of surfaces;
a processing section (45c) configured to generate correction information to carry out error correction processing in several units divided within surface units to the error correction block stored in the first storage section (42) on the basis of the intermediate information stored in the second storage sections (45a, 45b); and
control sections (43, 44, 46, 52, 53) configured to correlate position information of the error correction block stored in the first storage section (42) with position information in units of surfaces for use in the generating sections (45a, 45b), the second storage sections (47, 48) and the processing section (45c).

2. An error correction processing unit according to claim 1, **characterized by** further comprising:
a display section (51) configured to generate and display error map information on the basis of the information stored in the second storage sections (47, 48).

3. An error correction processing unit according to claim 1, **characterized in that**
the generating sections (45a, 45b) comprise:
a syndrome generating section (45a) configured to generate a syndrome as the intermediate information from data in units of surfaces of the input error correction block; and
an error flag generating section (45b) configured to generate an error flag as the intermediate information from the syndrome generated in the syndrome generating section (45a).

4. An error correction processing unit according to claim 1, **characterized in that**
the processing unit (45c) is configured to generate error pattern information and error position information as the correction information.

5. An error correction processing method **characterized by** comprising:
a first step (S1) of storing an error correction block having first and second surfaces (A/B) in a first storage section (42);
a second step (S2) of generating intermediate information for error correction processing in units of surfaces by generating sections (45a, 45b) from data of the first surface (A) of the error correction block stored in the first storage section (42);
a third step (S2) of storing intermediate information for the first surface (A) of the error correction block generated in the generating sections (45a, 45b) in the second storage sections (47, 48) in units of surfaces;
a fourth step (S6) of generating correction information to carry out error correction processing in several units divided within surface units for the data of the first surface (A) of the error correction block stored in the first storage section (42) by means of a processing section (45c) on the basis of the intermediate information for the first surface (A) of the error correction block stored in the second storage sections (47, 48);
a fifth step (S7) of generating intermediate information for error correction processing in units of surfaces by the generating sections (45a, 45b) from data of the second surface (B) of the error correction block stored in the first storage section (42);
a sixth step (S7) of storing the intermediate information for the second surface (B) of the error correction block generated in the generating sections (45a, 45b) in the second storage sections (47, 48) in units of surfaces; and
a seventh step (S12) of generating correction information to carry out error correction processing in several units divided within surface units for the data of the second surface (B) of the error correction block stored in the first storage section (42) by means of the processing section (45c) on the basis of the intermediate information for the second surface (B) of the error correction block stored in the second storage sections (47, 48).

6. An error correction processing method according to claim 5, **characterized by** further comprising:
an eighth step (S3, S8) of generating and displaying error map information on the basis of the intermediate information stored in the second storage sections (47, 48); and
a ninth step (S3 to S6, S7 to S9, S11, S12) of repeatedly carrying out a process of generating correction information to carry out error correction processing in several units divided within each of the surface units in accordance with the error map information generated in the eighth processes (S3, S8).

7. An optical disk device **characterized by** comprising:
a motor (12) configured to rotate and drive an optical disk (11);
a pickup (14) configured to read signals from the optical disk (11) which is rotated and driven by the motor (12);
a first storage section (42) configured to store an error correction block having first and second surfaces (A/B) from the signals read by the pickup (14);
generating sections (45a, 45b) to which the error correction block stored in the first storage section (42) is supplied in units of surfaces and which are configured to generate intermediate information for error correction processing in the units of surfaces;
second storage sections (47, 48) configured to store the intermediate information generated in the generating section (45a, 45b) in units of surfaces;
a processing section (45c) configured to generate correction information to carry out error correction processing in several units divided within units of surfaces for the error correction block stored in the first storage section (42) on the basis of the intermediate information stored in the second storage sections (47, 48); and
control sections (43, 44, 46, 52, 53) configured to correlate position information of the error correction block stored in the first storage section (42) with position information in units of surfaces for use in the generating sections (45a, 45b), the second storage sections (47, 48), and the processing section (45c).

8. An optical disk device according to claim 7, **characterized by** further comprising:
a display section (51) configured to generate and display error map information on the basis of the intermediate information stored in the second storage sections (47, 48); and
means (37) configured to repeatedly carry out a process of generating correction information to carry out error correction processing in several units divided within each of the surface units in accordance with the error map information.

9. An optical disk device according to claim 7, **characterized in that** the generating sections (45a, 45b) comprise:
a syndrome generating section (45a) configured to generate a syndrome as the intermediate information from data in units of surfaces of the input error correction block; and
an error flag generating section (45b) configured to generate an error flag as the intermediate information from the syndrome generated in the syndrome generating section (45a).

10. The optical disk device according to claim 7, **characterized in that** the processing section (45c) is configured to generate error pattern information and error position information as the correction information.
